Europäisches Patentamt

European Patent Office

Office européen des brevets

(19)

(11) Publication number : **0 486 248 A2**

## (12) EUROPEAN PATENT APPLICATION

(21) Application number : **91310405.5**

(22) Date of filing : **12.11.91**

(51) Int. Cl.⁵ : **G06F 15/60**

(30) Priority : **13.11.90 US 613189**

(43) Date of publication of application :
**20.05.92 Bulletin 92/21**

(84) Designated Contracting States :
**DE FR GB NL**

(71) Applicant : **Xilinx, Inc.**
**2100 Logic Drive**
**San Jose, California 95124 (US)**

(72) Inventor : **Perry, Steven J.**
**5333 Keene Drive**
**San Jose, California 95124 (US)**

(74) Representative : **Jones, Ian et al**
**W.P. THOMSON & CO. High Holborn House**
**52-54 High Holborn**
**London WC1V 6RY (GB)**

(54) Logic duplication method for reducing circuit size and delay time.

(57) Elements within a logic design which have a fan-out count greater than one are duplicated in order to reduce circuit size and/or minimize signal propagation time.

FIG. 1

EP 0 486 248 A2

EP 0 486 248 A2

## 1. CROSS-REFERENCE TO RELATED CO-PENDING APPLICATIONS

This application is related to the following co-pending applications, all assigned to the asssignee of the present application and all incorporated herein by reference:

(a) European Patent Application 90 305 142.3 (0 398 605), based on US Application 07/351,888 filed May 15, 1989.

(b) U.S. Application 07/456,010 for "Structure and Method for Manually Controlling Automatic Configuration in an Integrated Circuit Logic Block Array", filed December 20, 1989.

(c) European Patent Application 90 308 210.5 (0 410 759), based on U.S. Application 07/387,566 filed July 28, 1989.

(d) European Patent Application 91 304 129.9 (0 456 475), based on U.S. Application 07/522,336 filed May 10, 1990.

(e) European Patent Application 91 302 681.1 (0 449 608), based on U.S. Application 07/499,759 filed 27 March 1990.

## 2. CROSS REFERENCE TO RELATED PATENTS

The disclosures of the following U.S. patents are incorporated herein by reference:

(a) U.S. Patent 4,870,302, [Attorney Docket No. M-197/2,] Title: "Configurable Electrical Circuit Having Configurable Logic Elements and Configurable Interconnects", issued to Ross Freeman, September 26, 1989

(b) U.S. Patent 4,706,216, [Attorney Docket No. M-211,] Title: "Configurable Logic Element", issued to William S. Carter, November 10, 1987.

(c) U.S. Patent 4,642,487, [Attorney Docket No. M-213,] Title: "Special Interconnect for Configurable Logic Array", issued to William S. Carter, February 10, 1987.

(d) U.S. Patent 4,695,740, [Attorney Docket No. M-214,] Title: "Bidirectional Buffer Amplifier", issued to William S. Carter. September 22, 1987.

(e) U.S. Patent 4,855,619, [Attorney Docket No. M-614,] Title: "Buffered Routing Element for a User Programmable Logic Device", issued to H. Hsieh and William S. Carter, August 8, 1989.

(f) U.S. Patent 4,835,418, [Attorney Docket No. M-615,] Title: "Three-State Bidirectional Buffer", issued to H. Hsieh, May 30, 1989.

The present invention is generally directed to a method for laying out electronic circuit components across a surface area of a circuit supporting substrate. The circuit components are interconnected to implement a set of pre-defined high-level functions such as Boolean logic functions or other functions. Limitations are set on the number of primitive functions that each subsection of the substrate surface area can support. The method of the invention seeks to use as much as possible of the function implementing resources available in each substrate subsection.

The invention is also directed to the product of such a method.

The invention is more specifically directed to a layout method used in and the product created from configuring the circuitry of a field-programmable configurable logic array (FP-CLA).

The fabrication of an integrated circuit chip begins with an initial functional description that defines the operations to be carried out on the integrated circuit chip. Typically, this initial functional description is in the form of a schematic diagram which is drawn at the primitive component level (e.g., the 2-input gate level). When a computer-aided design system (CAD) is used, the functional description will also be in the form of a computer-readable "net list" which describes a set of function primitives and their interconnections. The initial functional description is usually defined by a long list of many (i.e.. hundreds of) functional elements (primitives) such as 2-input AND or OR logic gates, inverters, flip flops, tri-state line drivers, etc. These elements are sometimes referred to as "instances". The input and output terminals of these elements are appropriately interconnected by linkages or "nets" to provide a desired set of higher-level functions. The term "net list" is often used to refer to a database which defines relations between the input/output terminals (or "pins") of each instance and the nets which interconnect these terminals.

For the sake of simplification, the terms "logic design" and "circuit design" will be used here interchangeably with "functional description". Schematic drawings will be used to represent logic designs as defined either by the drawings themselves or by computer representations of the schematic drawings (computer readable net-list files). A logic design does not describe the physical location of circuit components or interconnect wiring as they will appear on the physical chip. That is defined during the layout process. The end product of circuit design, circuit layout and physical implementation is referred to here as the "physical circuit".

In a first step of the layout and implementation process, the logic design (net list) is subdivided or "par-

2

titioned" into design sections where each design section has no more than a predefined maximum number of primitives (e.g., 2-input Boolean logic gates). This first step is carried out so that each partitioned design section can be later associated with and implemented by a corresponding function-implementing subsection of the integrated circuit chip.

Each function-implementing subsection of the chip has a pre-defined upper bound on the number of primitive functions that it can accommodate. To make implementation possible, the number of function elements (e.g., Boolean logic gates) in each partitioned design section should, be equal to or less than the upper bound value of a corresponding function-implementing subsection on the chip substrate.

After partitioning, the circuitry which implements the functions of each design section, either directly or by equivalence, is defined. The circuitry of each design section (referred to here as a "design-section circuit") is then formed and fixedly placed on a corresponding function-implementing subsection of the chip substrate. Finally, with the physical location of each design-section circuit being fixed, interconnecting conductors are routed between the design-section circuits to complete the integrated circuit. The above steps are commonly referred to in the industry as "partitioning", "placement", and "routing".

In the past, the partitioning, placement and routing design steps were carried out manually by skilled practitioners who are referred to as layout artists. These artists generally work for large semiconductor fabricating companies and they often spend many years learning how to best define the layout of mass-produced integrated circuit chips using a series of photolithographic "masks". The artists have developed empiric skills over the years which enable them to pack circuits and functions onto chips at relatively high densities thus making efficient use of the limited area on each chip.

Recently. a wide variety of so-called "field programmable logic devices" (PLD's) or "user configurable logic arrays" (CLA's) have been introduced. Such field programmable devices give field users the flexibility of programmably creating circuits in the field. But such PLD's also move the burden of chip layout from experienced in-house layout artists to inexperienced field users. The field users, in general, are unwilling or unable to spend time learning how to efficiently layout their circuits in a PLD (or CLA) so that the limited real estate of a single PLD chip is efficiently used.

To ease the burden on field users, a number of computer-automated partitioning, placement and routing systems have been proposed. The foundation of most automated partitioning systems lies in a so-called "min-cut" algorithm which was developed at Bell Laboratories. See B.W. Kernighan and S. Lin, "An Efficient Heuristic Procedure for Partitioning Graphs", Bell System Technical Journal, Vol. 49, February, 1970, pp. 291-308. See also U.S. Patent No. 3,617,713, "Method of Minimizing the Interconnection Cost of Linked Objects", Issued November 2, 1971 to Kernighan and Lin.

The idea behind the min-cut algorithm is to bundle a number of electrical components into separate design sections such that a minimum number of wires pass between the design sections. The min-cut algorithm starts with a first partitioning line that divides a circuit design into two halves, where each half contains approximately an equal number of basic electrical components. A count is taken of the number of interconnect wires that are cut by the first partitioning line. Next, an arbitrarily selected component on the left side of the partitioning line and a corresponding arbitrarily-chosen component on the right side of the partitioning line are swapped across the partitioning line (while their interconnections are maintained). The number of wires cut by the partitioning line after the swap is counted. If the new count is less than the old count, the swap is maintained, otherwise a different swap is attempted.

The swap and test process is repeated many times until a user-defined stop condition arises. Ultimately, the min-cut algorithm is supposed to define a partitioning line which cuts through a minimum number of interconnect wires. The two design sections defined at the sides of the partitioning line are then individually subdivided by drawing a new partitioning line in each design section and reapplying the min-cut algorithm separately to the two design sections. The process is repeated recursively until a stop condition is met. It was believed that such recursive application of the min-cut algorithm would automatically partition circuit designs much like the human layout artists. But experience has proved otherwise.

Since the introduction of the min-cut algorithm, a number of improvements to its approach have been reported. See for example, "Analysis of Placement Procedures for VLSI Standard Cell Layout", Mark Hartoog, 23rd Design Automation Conference, IEEE, 1986, pp. 314-319. See further: "A Class of Min-Cut Placement Algorithms", Melvin Breuer, University of Southern California, 16th Design Automation Conference, June 1977, pp. 284-290; "Circuit Layout", Jiri Soukup, Bell Labs, Proc. IEEE, vol. 69, Oct. 1981, pp. 1281-1304; and "Optimization by Simulated Annealing", S. Kirkpatrick et al., IBM, Science vol. 220, May 13, 1983, pp. 671-680. (See also "Chortle: A Technology Mapping Program for Lookup Table-Based Field Programmable Gate Arrays", Robert J. Francis, et al., University of Toronto, 27th ACM/IEEE Design Automation Conference, June 1990, pp. 613-619 [not prior art for this application].)

The automated-partitioning systems available until now still do not perform as well as the human layout artists. The number of wire cuts or design sections generated by a partitioning algorithm is only one measure of the "goodness" of a partitioning procedure; circuit packing density and signal delay characteristics should also be considered.

## SUMMARY OF THE INVENTION

The present invention provides a computer-automated partitioning system which seeks to automatically maximize circuit packing density and/or minimize signal propagation delay in the physical implementation of a given circuit design. Typically, the circuit design is a computer-readable net-list file and the desired end product (physical implementation) is an integrated circuit chip (IC). The invention may be used to automatically and efficiently define a circuit in a user-configurable logic array (FP-CLA).

A method in accordance with the invention starts by searching through a circuit design and tagging as a "duplication-candidate" each active circuit element which has an output terminal driving more than one input terminal in a set of next succeeding circuit elements. Once such "multiple fan-out" circuit elements are tagged, duplicates of each tagged circuit element are made and inserted into the original circuit design in place of the original multiple fan-out element. The corresponding input terminals of the duplicates are joined together. The output terminals of the duplicates are not joined together but rather, the output terminal of each duplicate is joined to a corresponding single input terminal in the set of next succeeding circuit elements.

After duplication, a test is conducted to determine whether packing density can be increased and/or signal propagation time decreased as a result of the duplication. In many instances, packing density increases because one or more of the single fan-out, duplicated logic elements may be incorporated into a function-implementing subsection of the integrated circuit chip which could not have previously contained the multiple fan-out original. The incorporation of the single fan-out duplicates into respective function-implementing subsections tends to reduce wire length between the single fan-out duplicates and other circuit elements they are connected to. This in turn reduces signal delay time. A more detailed explanation of how packing density is increased and/or signal propagation time is reduced will be found below.

The invention is further described below, by way of example, with reference to the accompanying drawings, in which:

Figure 1 shows a sample digital logic design which is to be implemented in a configurable logic array (CLA) device;

Figure 2A is a top plan view of the CLA device which is to be configured to implement the logical functions illustrated in Figure 1;

Figure 2B is an enlarged top view showing further details of function-implementing subsections found on a section of the CLA ship shown in Figure 2A;

Figure 3A illustrates a first partitioning of a given design portion where the partitioning attempts to satisfy a boundary rule that corresponds to the limited capabilities of each function-implementing subsection of Fig. 2B;

Figure 3B shows a second partitioning of the given circuit design;

Figure 4 shows an element duplication step and the resulting partitions which are made possible by this element duplication step;

Figure 5A is a flow chart of a partitioning optimization process in accordance with the invention;

Figure 5B is a flow chart of a propagation delay minimization process in accordance with the invention;

Figure 5C illustrates the nets, pins and instances concept;

Figures 5D-5F illustrate respective parts of a computer-readable memory device on which there is defined a net-list database comprising a nets table, an instances table and a pins table;

Figure 6A is a top plan view of a CLA chip having an array of configurable logic blocks (CLB's), switching matrices (SWM's) and interconnect busses defined on its substrate;

Figure 6B is a block diagram of a configurable logic block (CLB);

Figure 6C is a top plan view showing the physical orientation of input and output terminals on the CLB's of Fig. 6A in relation to external interconnect wires.

Figure 7A shows a Boolean tree structure.

Figure 7B illustrates an optimum mapping of the Fig. 7A tree structure into a set of CLB's.

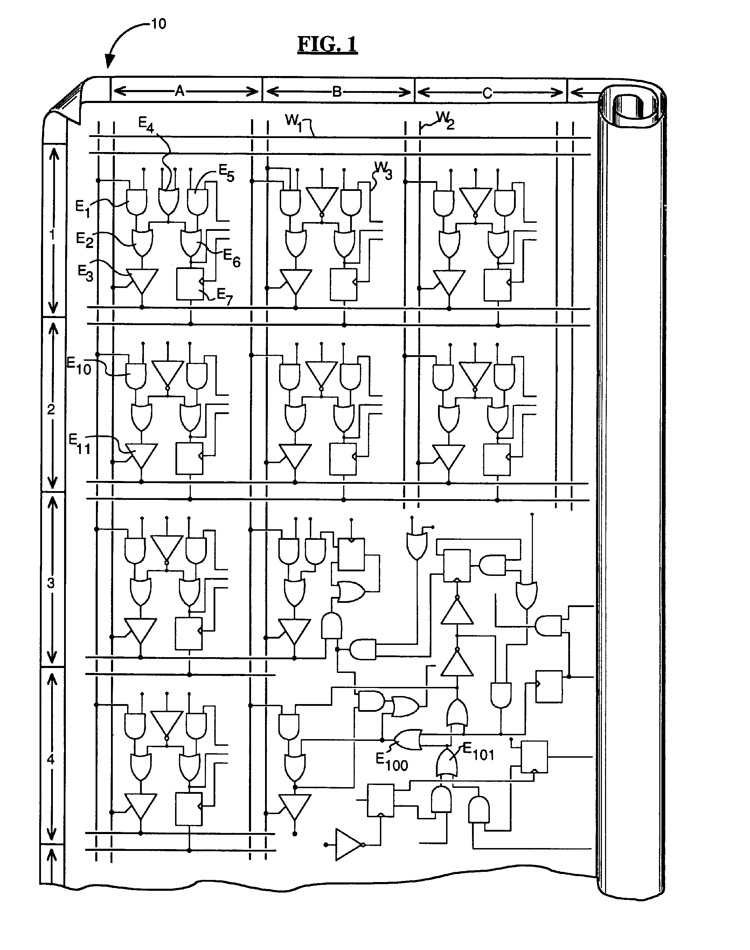

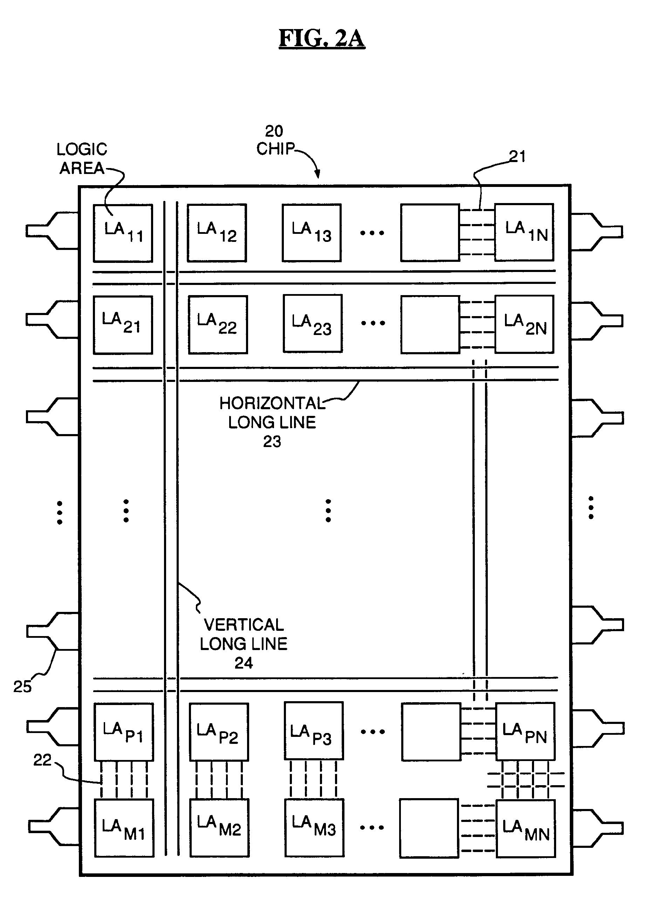

Referring to Figure 1, a distinction should again be made between a functional description ("logic design" or "circuit design") of a circuit that is to be implemented and the actual implementation of that circuit (physical circuit, including final layout). Figure 1 illustrates a sheet of paper 10 on which a sample logic design is drawn. The logic design comprises a set of icons representing a large number of primitive-function elements including, by way of example, a first AND gate ($E_1$), a first OR gate ($E_2$), a tri-state buffer ($E_3$), a second OR gate ($E_4$), a second AND gate ($E_5$), a third OR gate ($E_6$), a flip-flop ($E_7$), and a plurality of both long and short (as drawn on

paper) interconnect wires ($W_1$, $W_2$, $W_3$, . . .) extending in all directions to couple the input and output terminals of these logic elements ($E_1$-$E_7$) to one another as well as to the terminals of other logic elements (e.g., $E_{10}$ and $E_{11}$) also drawn on the surface of design sheet 10. Most of the illustrated circuit elements ($E_1$-$E_7$) may be defined as "Boolean logic primitives" because each has only one signal output terminal (a one bit output) and no more than three or four signal input terminals.

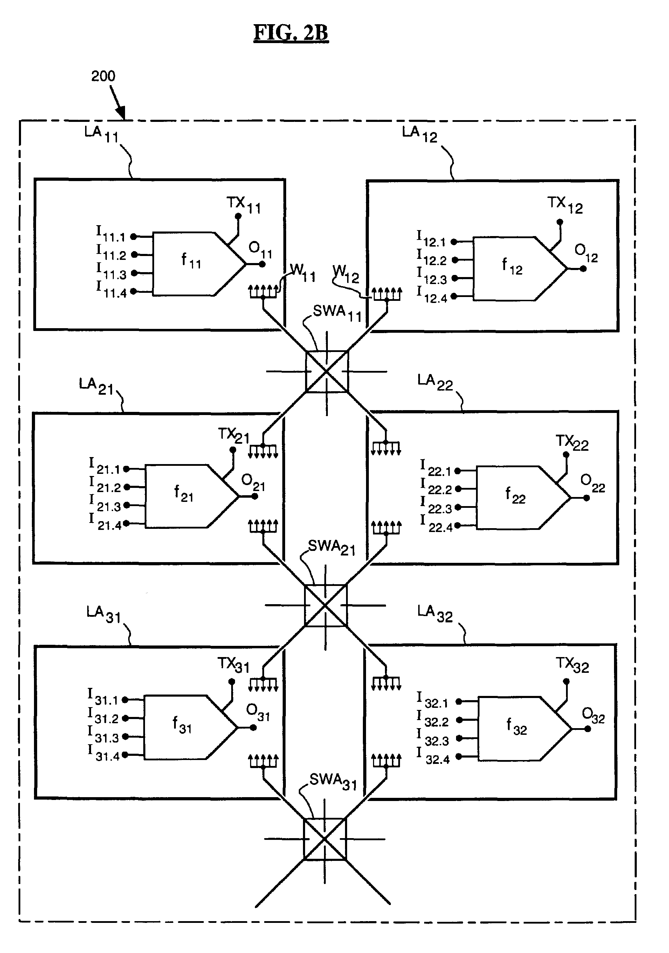

For ease of reference, the design sheet 10 includes mapping coordinates which designate columnar regions by capital letters, A, B, C, etc., and orthogonal row regions , by numerals, 1, 2, 3, etc. Functional elements $E_1$-$E_7$ are seen to fit within what appears to be a self-partitioning top left area A1 of the design sheet 10. Other elements (e.g., $E_{100}$ and $E_{101}$) are seen to be randomly scattered across bottom right areas such as C4 of the illustrated design sheet 10. It is to be understood that the self-partitioning areas A1-A4, B1, B2, C1, C2 of the design sheet 10 are atypical. Most design sheets contain a so-called "rat's nest" or "spaghetti bowl" distribution of logic icons (appearing to be randomly scattered and interconnected) as better represented by area C4. A conceptually suggestive degree of order is illustrated in areas A1-C2 merely to facilitate an initial understanding of how the elements drawn on sheet 10 might be rearranged and associated with function-implementing subsections of a soon-to-be-described integrated circuit chip (Figure 2A).

Normally, a logic design starts out as a disorderly collection of function elements (e.g., as shown in area C4). These elements are repositioned during the layout process (while keeping all interconnect wiring intact in the logical sense as opposed to the physical sense), until the function elements appear to be bundled into reasonably sized groups (e.g. areas A1, A2) such that the functions of each group can be implemented by a function-implementing subsection of the physical end product.

In the layout process, two questions need to be simultaneously considered. The first is how to define electrical circuitry which meets the requirements of the logic design, either directly or by equivalence. The second is how to keep this circuitry within the physical limitations of the function-implementing end product. A specific kind of function-supporting substrate will be described first and then a sample partitioning problem will be presented.

Referring to Figure 2A, there is shown a top plan view of a monolithic semiconductor substrate (chip) 20 having a regular array of user-programmable logic-implementing sub-areas, $LA_{11}$, $LA_{12}$, $LA_{13}$, ..., $LA_{IN}$, $LA_{21}$, ..., $LA_{2N}$, .... $LA_{MN}$, uniformly defined across its surface. The chip 20 is referred to as a configurable logic array (CLA). The logic-implementing sub-areas, $LA_{11}$-$LA_{MN}$, of the CLA chip 20 are generally referred to as "logic areas", $LA_{xy}$, where x and y are identifying integers or coordinates.

At first, the internal circuitry of the logic areas $LA_{xy}$ are undefined (not configured), but after layout and configuration is completed, this configurable logic array (CLA) chip 20 has physical circuitry defined on it to implement the logical functions described by a user-provided functional description such as the schematic symbols of design sheet 10 (Figure 1).

The CLA chip 20 includes a matrix of physically-short horizontal wires 21 and physically-short vertical wires 22 distributed across its surface for interconnecting the logic areas. Only a few of these wires are shown in Fig. 2A to avoid illustrative clutter. Ends of the short wires, 21 and 22, (whose horizontal and vertical end relations are more fully shown in the area between $LA_{PN}$ and $LA_{MN}$) may be linked to each other and to adjacent logic areas in order to couple input and output terminals of the logic areas one to the next. Programmable interconnect joints (not shown) may be used to link the North. South. East or West ends of the vertical and horizontal wires, 21 and 22, in a variety of ways (e.g., a North end of a vertical wire may be coupled to an East end of a horizontal wire) in order to form longer wires of varying shapes and lengths.

Physically-long horizontal wires 23 and physically-long vertical wires 24 (global wires) are also provided extending across substantially the entire chip 20 for interconnecting widely spaced-apart logic areas one to the next (e.g., for interconnecting $LA_{11}$ to $LA_{P2}$). The chip 20 further includes input/output blocks (IOB's, not shown) for coupling various input and output terminals of the logic-implementing areas $LA_{11}$-$LA_{MN}$ to input/output pins 25 provided around the periphery of the chip 20.

Referring to Figure 2B, an enlarged view of one substrate section 200 containing logic areas $LA_{11}$-$LA_{32}$ is shown. Each logic area $LA_{xy}$ is shown to contain a function generating circuit $f_{xy}$ having only four input terminals $I_{xy.1}$, $I_{xy.2}$, $I_{xy.3}$, $I_{xy.4}$ and a single output terminal $O_{xy}$. A tristate control terminal $TX_{xy}$ may be used to optionally place the output terminal $O_{xy}$ in a high impedance state. (The subscript xy refers here to the identifying integers or coordinates of function generators $f_{11}$-$f_{32}$.)

For simplicity we assume that each logic-supporting area $LA_{xy}$ of Figure 2B can be configured (programmed) to implement any combinatorial logic function having only a single output bit and no more than four input bits. An example of a configurable function generator $f_{xy}$ having such limited capabilities is a table lookup memory unit having only four address input terminals ($I_{xy.1}$-$I_{xy.4}$), only sixteen memory cells ($2^4$ bits) and only one data output line ($O_{xy}$).

Inter-area connecting wires $W_{11}$, $W_{12}$,. etc., which extend out of the logic areas, are available to couple any one or more of the four input terminals, the tristate control terminal and the single output terminal of each function generator $f_{xy}$, to a nearby switch matrix area, $SWA_{xy}$. Each switch matrix area, $SWA_{xy}$, may be programmed to route signals between the input/output terminals of a first generator $f_{xy}$ and other inter-area wires going to the signal input or output terminals of other function generators $f_{x'y'}$.

The problem of forming signal routing paths with the inter-area connecting wires ($W_{11}$, $W_{12}$, etc.) and the switch matrix areas ($SWA_{11}$, $SWA_{21}$, etc.) will not be discussed in detail here except to mention that there is a finite signal propagation time attributed to each of the relatively long inter-area connecting wires ($W_{11}$, $W_{12}$, etc.) which extend out from a first logic-supporting area (e.g. $LA_{11}$) to a second logic-supporting area (e.g. $LA_{12}$) and/or the wire-joining switch matrices ($SWA_{11}$, $SWA_{21}$, etc.). It is generally desirable to minimize the length and/or number of such inter-area (out-of-area) wires when routing signals through the physical (end product) circuit so that signal propagation time will not become excessively long. A finite but relatively shorter signal propagation time is attributed to shorter intra-area (within-the-logic-area) connections (not shown in Fig. 2B) that are provided entirely inside each logic-supporting area (e.g., within $LA_{12}$). It is generally desirable to route signals by using the shorter intra-area wires (not shown) rather than the longer inter-area wires ($W_{11}$, $W_{12}$, etc.) where possible.

It should be mentioned additionally that when the function generator $f_{xy}$ of each logic-supporting area $LA_{xy}$ includes a table lookup memory, there is a finite time delay imposed for addressing individual memory cells within that function generator $f_{xy}$. The delay imposed on a signal when traveling from the output terminal (e.g.. $O_{11}$) of a first logic area ($LA_{11}$) to the input terminal ($I_{12.2}$) of a second logic area ($LA_{12}$) and through the function generator ($f_{12}$) of the second logic area ($LA_{12}$) to produce a response at the output terminal ($O_{12}$) of the second area ($LA_{12}$) will be referred to here as an "inter-area" delay. When a Boolean tree logic is implemented with a series of logic areas ($LA_{11}$, $LA_{12}$, $LA_{13}$, etc.), it is generally preferable to minimize the number of logic areas and/or the distances between them so that the sum of inter-area delays is minimized for logic signals propagating through the Boolean tree.

Now that some constraints involved in a physical implementation (chip 20 of Figs. 2A and 2B) are understood, a sample (first level) partitioning problem is presented.

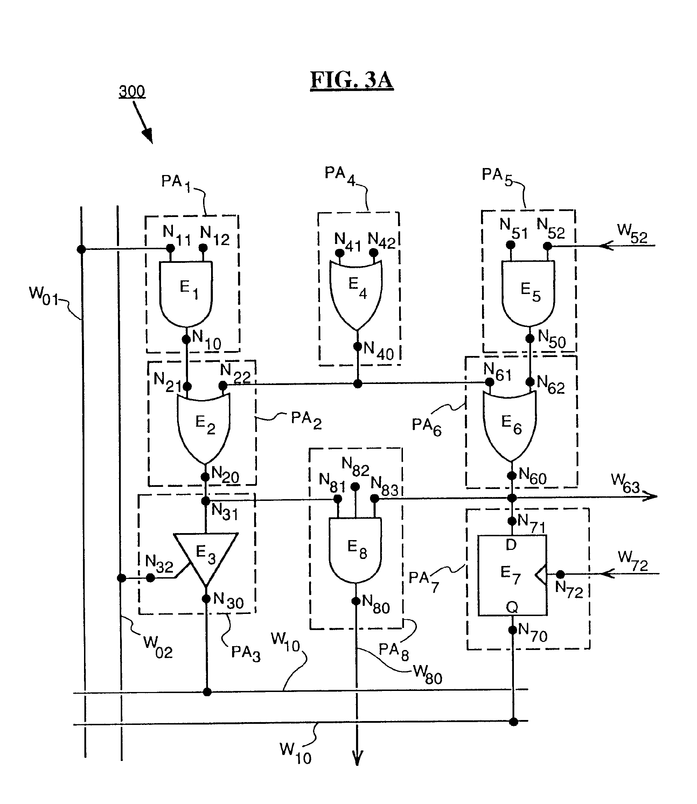

Referring to Figure 3A, a sample section 300 of a circuit design is illustrated to explain how logic functions are re-arranged schematically and ultimately mapped into the fixed logic-supporting areas of a user-configurable chip 20 (Fig. 2A) by way of partitioning and placement.

Design section 300 is shown to include a plurality of electrical components (or elements), $E_1$, $E_2$, $E_3$, ..., $E_8$ where each element $E_z$ has a single output node $N_{z0}$ and one or more input nodes, $N_{z1}$, $N_{z2}$, $N_{z3}$, etc. (z represents identifying integers, 1, 2, 3, etc., here). The number of unique input nodes, $N_{z1}$, $N_{z2}$, $N_{z3}$, etc. which an individual circuit element $E_z$ has is defined as the element's "fan-in". The number of succeeding input nodes that are driven by the output node $N_{z0}$ of that element $E_z$ is defined as the "fan-out" of that element $E_z$. Thus, the illustrated AND gate $E_1$ has a fan-in of 2 and a fan-out of 1; the illustrated OR gate $E_4$ has a fan-in of 2 and a fan-out of 2; and the illustrated AND gate $E_8$ has a fan-in of 3 but an unknown fan-out because it's succeeding logic elements are not shown.

We assume that the dashed boxes $PA_1$-$PA_8$ of Fig. 3A are not yet drawn around respective elements $E_1$-$E_8$. The problem at hand is how is to implement this design section 300 in the CLA chip 20 of Fig. 2A under the constraint that each logic supporting area $LA_{xy}$ can admit no more than four input wires ($I_{xy.1}$-$I_{xy.4}$) or one tri-state control wire ($TX_{xy}$) and can have no more than one output wire ($O_{xy}$) leaving it. (See Fig. 2B). This upper bound on the number of input wires entering a logic area $LA_{xy}$ and the number of output wires leaving the same logic area $LA_{xy}$ will be referred to as the boundary rule, $BR_{xy}$, of the logic area $LA_{xy}$. For now we will assume that the boundary rule, $BR_{xy}$, for each logic area is the same: 4 or less input wires (plus a tri-state control wire) and only 1 output wire.

A simple approach is to surround each primitive element $E_z$ (i.e., each 2-input/1-output AND or OR gate) with a corresponding partitioning box. $PA_z$, as shown in Fig. 3A. This automatically assures that the number of input and output wires passing into each box $PA_z$ will satisfy the boundary rule. $BR_{xy}$. (x. y and z are identifying integers here.) The area contained within each partitioning box $PA_z$ is referred to here as a partitioning area and is also denoted by $PA_z$.

Once this simplistic partitioning of Fig. 3A is performed to satisfy the boundary rule, $BR_{xy}$, the equivalent circuitry of each individual partitioning area $PA_z$ is configured into a corresponding function generator $f_{xy}$ in a single logic-supporting area $LA_{xy}$ of the chip 20 (Fig. 2A), inter-area connecting wires are formed and the physical circuit is thereby realized.

But this simple-minded approach of Fig. 3A is inefficient. It maximizes the number of logic-supporting areas $LA_{11}$, $LA_{12}$, $LA_{13}$, etc. that will be used in the end product 20. The chip's packing density is disadvantageously minimized and this in turn maximizes the lengths and/or number of inter-area wires ($W_{11}$, $W_{12}$, etc.) that are used between the functional elements $E_1$, $E_2$, $E_3$, etc., thereby undesirably maximizing signal propagation time.

If there is a small and thus very limited number of inter-area connecting wires available on the chip 20, using many such wires for connecting the elements $E_1$-$E_8$ to one another may prevent other connections from being made during the wire routing process. Also, in the case where each function generator includes a memory cell addressing means, signal propagation delay is further increased because signals have to propagate through a series of such memory addressing means (the sum of inter-area delays is maximized along each series circuit).

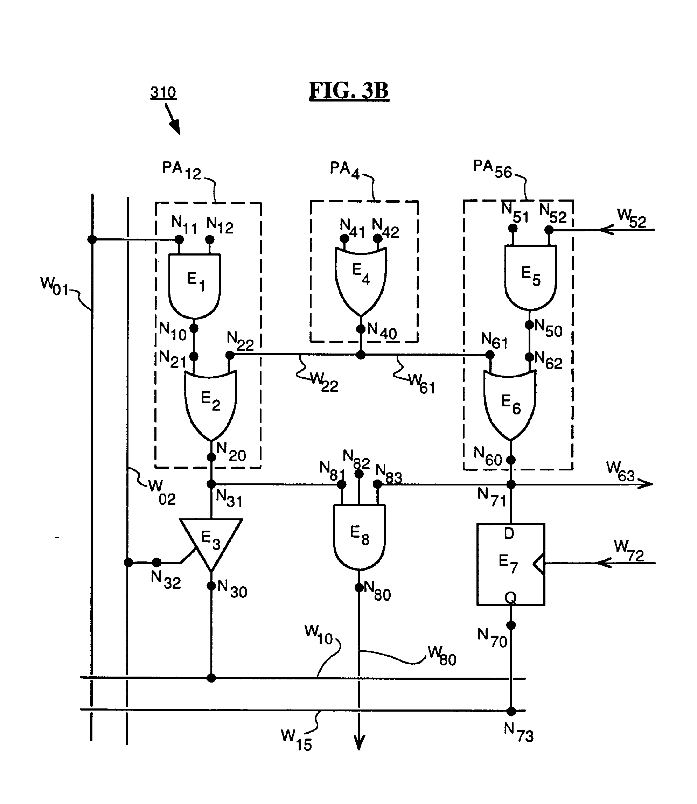

Referring to Figure 3B, a second approach to partitioning the same design section 300 is shown at 310. It is observed that output node $N_{20}$ of the first OR gate ($E_2$) can be the single output terminal of a first function generator $f_{11}$, associated with partition area $PA_{12}$ while input nodes $N_{11}$, $N_{12}$ and $N_{22}$ define three of the available four input terminals ($I_{11.1}$-$I_{11.3}$) of this function generator $f_{11}$. The fourth input terminal ($I_{11.4}$) of $f_{11}$ is grounded and thus not used. The second OR gate ($E_4$) cannot participate in partitioning area $PA_{12}$ because its output terminal $N_{40}$ is independent of the $N_{20}$ output node already supported by partition area $PA_{12}$. Accordingly, a separate partitioning box $PA_4$ must still be drawn around the second OR gate ($E_4$). If the second OR gate ($E_4$) had been included within partitioning area $PA_{12}$, then that partitioning area $PA_{12}$ would have had two independent output terminals extending from it, and this would violate the boundary rule, $BR_{xy} = \{inputs < 4, outputs = 1\}$. Partitioning box $PA_{56}$ satisfies the boundary rule by surrounding elements $E_5$ and $E_6$ to define three box input lines and one box output line. It should be noted that node $N_{40}$ of second OR gate ($E_4$) fans out to supply signals to a plurality of next succeeding input nodes (to nodes $N_{22}$ and $N_{61}$ of next-succeeding OR gates, $E_2$ and $E_6$).

Referring back to Fig. 2B, we will assume that the circuity of partitioning area $PA_{12}$ (Fig. 3B) is implemented by function generator $f_{11}$; the circuitry of partitioning area $PA_4$ is implemented by function generator $f_{12}$; and the circuitry of partitioning area $PA_{56}$ is implemented by function generator $f_{22}$. The circuitry for implementing the functions of $E_3$, $E_8$ and $E_7$ is not considered here.

There is still a degree of inefficiency in the Fig. 3B approach. By implementing the 2-input OR function $E_4$ of partitioning area $PA_4$ in the 4-input function generator, $f_{12}$, we waste half the logic-implementing resources of that function generator $f_{12}$. A signal traveling from input node $N_{41}$ (assume it to be $I_{12.1}$), through gate $E_4$ (function generator $f_{12}$) over inter-area wire $W_{22}$ to input node $N_{22}$ (assume it to be $I_{11.3}$ of function generator $f_{11}$) would be subject to the input delay of function generator $f_{12}$ as well as the inter-area delay associated with traveling from output terminal $O_{12}$ through switching matrix $SWA_{11}$ to input terminal $I_{11.3}$ and the further input delay of function generator $f_{11}$. A signal propagating from node $N_{42}$ over inter-area wire $W_{61}$ to node $N_{60}$ would be subject to similar delays.

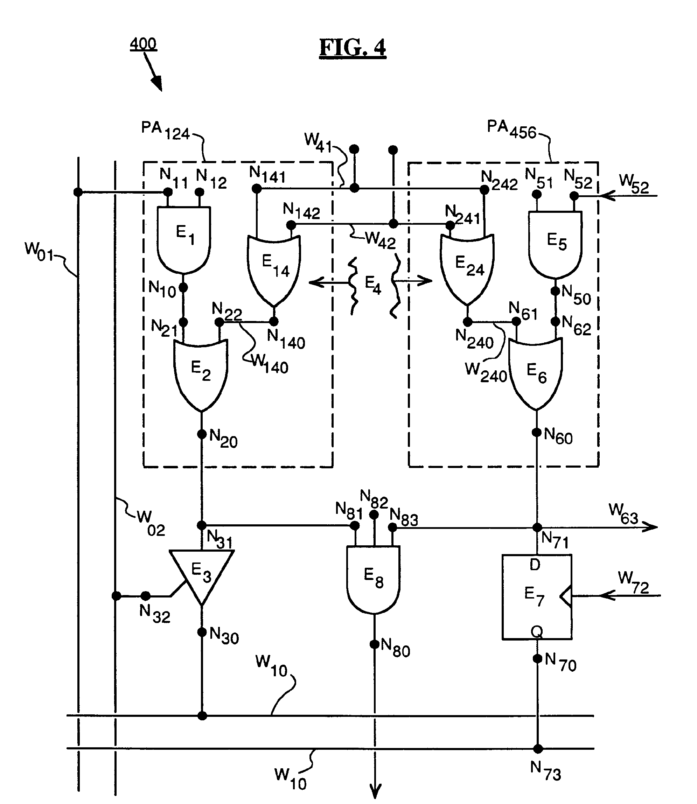

Referring to Figure 4, a pre-partitioning step in accordance with the invention is conceptually illustrated. Element $E_4$ is identified as a "duplication-candidate" because it has a fan-out number greater than one and a fan-in less than four. This identified element $E_4$ is replaced with two duplicate elements, $E_{14}$ and $E_{24}$. The corresponding input nodes $N_{141}$ and $N_{241}$, of the duplicates are joined together by out-of-area (inter-area) wire $W_{41}$ and the further corresponding nodes $N_{142}$ and $N_{242}$ are joined together by out-of-area (inter-area) wire $W_{42}$. The corresponding output nodes, $N_{140}$ and $N_{240}$, of the duplicates are not joined together but rather each output node is independently connected by a within-area (intra-area) wire ($W_{140}$ or $W_{240}$) to one of the next-succeeding input nodes ($N_{22}$ and $N_{61}$) that were previously driven by the output node $N_{40}$ of the original OR element $E_4$. As a result of this duplication process, it is now possible to draw a first partitioning box $PA_{124}$ which encircles elements $E_1$, $E_2$ and $E_{14}$ without violating the boundary rule. It is further possible to draw a second partitioning box $PA_{456}$ which encircles elements $E_{24}$, $E_5$ and $E_6$ without violating the boundary rule.

We now compare the partitioned logic design of Fig. 4 against the partitioned logic design of Fig. 3B and see that the Fig. 4 approach has several advantages. Where the logic design of Fig. 3B required three logic-supporting areas ($LA_{11}$, $LA_{12}$, $LA_{22}$) to implement the functions of elements $E_1$, $E_2$, $E_4$, $E_5$ and $E_6$; the logic design 400 of Fig. 4 requires only two logic-supporting areas to implement the same functionality. Remarkably, the number of logic-supporting areas, $LA_{xy}$, required for implementing the functions of elements $E_1$, $E_2$, $E_4$, $E_5$ and $E_6$ has been reduced 33 1/3% by increasing the number of logic elements (by duplicating element $E_4$). The connection between nodes $N_{140}$ and $N_{22}$ is now formed with a within-the-area (intra-area ) conductor $W_{140}$ rather than by an out-of-area (inter-area) connection ($W_{22}$ of Fig. 3B). The connection between nodes $N_{240}$ and $N_{61}$ is similarly made over $W_{240}$ instead of over $W_{61}$ (Fig. 3B). All 4-input terminals, $I_{11.1}$-$I_{11.4}$ and $I_{12.1}$-$I_{12.4}$, of respective function generators $f_{11}$ and $f_{12}$ are used rather than just two or three (as in Fig. 3B). There is no inter-area delay between nodes $N_{141}$ and $N_{20}$ or between nodes $N_{242}$ and $N_{60}$.

The element duplication step is not limited to elements with a fan-in of two. Elements with any fan-in value less than or equal to the fan-in limit of the boundary rule (in the example it was set as 4 corresponding to $I_{xy.1}$-$I_{xy.4}$) can be duplicated and tested to see if such duplication reduces delay and/or the number of partitioning boxes $PA_z$ and hence the number of ultimately-utilized logic-supporting areas $LA_{xy}$.

There is a point where element duplication may become counter-productive. If a duplication candidate has a relatively high fan-in value (i.e.. 4 input terminals) or a relatively high fan-out value (i.e.. it drives more than say five succeeding input nodes), then element duplication might simply increase the number of required function generators or introduce a substantially larger and thereby undesirable number of new inter-area connection wires into the logic design. Thus, the element duplication process should be applied within limits.

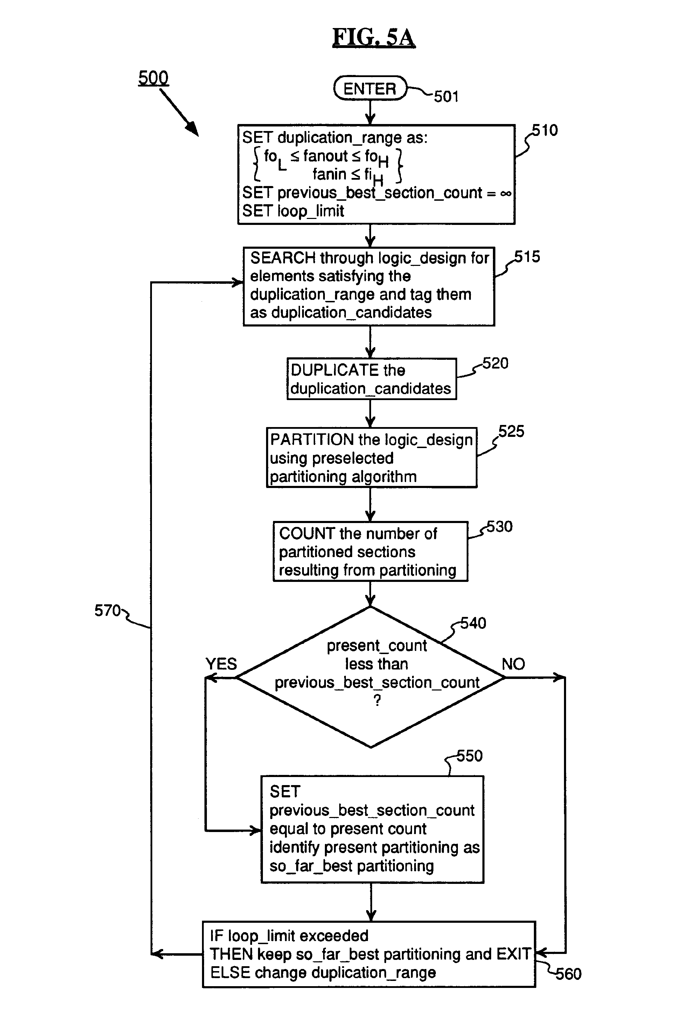

Referring to Figure 5A, there is shown a flow chart of an automated process 500 used within a computer automated layout system according to the invention for identifying an optimum duplication range and producing a partitioned logic design according to the optimized duplication range. Any computer hardware used for computer-aided design (CAD) may be used to implement the automated process. A Sun-4 workstation from Sun Microsystems of Mountain View, California is an example.

The automated process 500 is started at step 501. At initialization step 510, an initial duplication range is set with the limits $fo_L \leqq$ fanout $\leqq fo_H$ and fanin $\leqq fi_H$; where $fo_L$ and $fo_H$ are respective low and high limits for fan-out values and $fi_H$ is a maximum value for fan-in counts. For the boundary rule of Fig. 2B ($BR_{xy}$ = 4 or less inputs/1 output) one may start with $fo_L$ = 2, $fo_H$ = 3 and $fi_H$ = 2 as an initial range.

Initialization step 510 further includes house-keeping sub-steps such as the setting of a previous-best-selection-count to infinity (or an equivalent large number, e.g., $FFFF_{hex}$) and the setting of a pre-defined loop limit for process 500.

At a next step 515, the logic design is searched through for elements having fan-in and fan-out values within the duplication range and these elements are tagged as duplication candidates. Next, at step 520 the duplication candidates are duplicated in accordance with the process of Fig. 4. At step 525 the logic design, which now includes the duplicated elements, is partitioned using a pre-selected partitioning algorithm. The partitioning algorithm defines partitioning boxes $PA_z$ around groups of one or more elements $E_1$, $E_2$, etc., such that each partitioning box $PA_z$ satisfies a predefined boundary rule (i.e., no more than J input terminals and K output terminals for each function-implementing area $LA_{xy}$) while trying not to waste the resources of the logic areas.

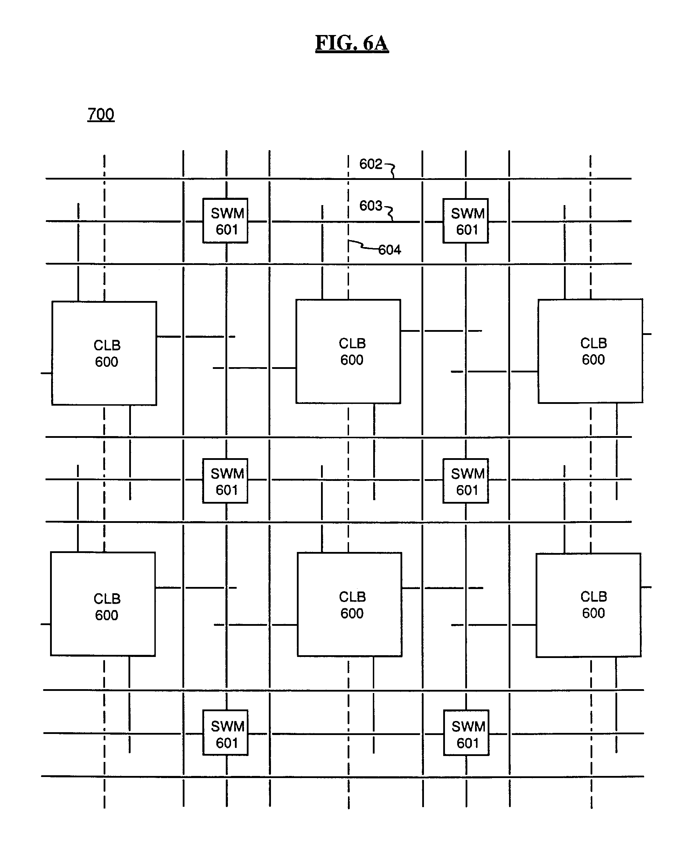

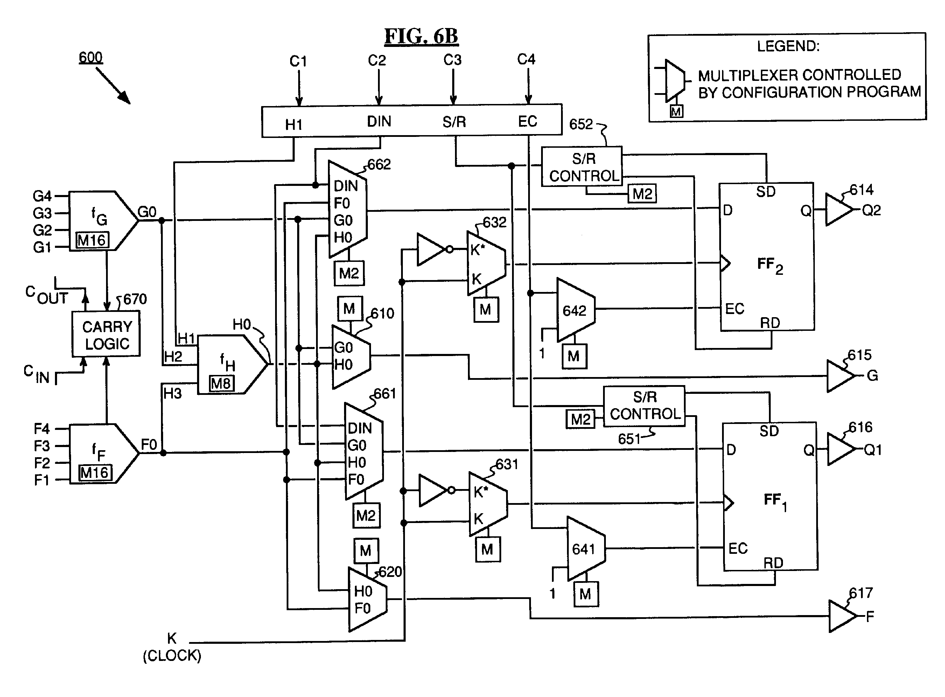

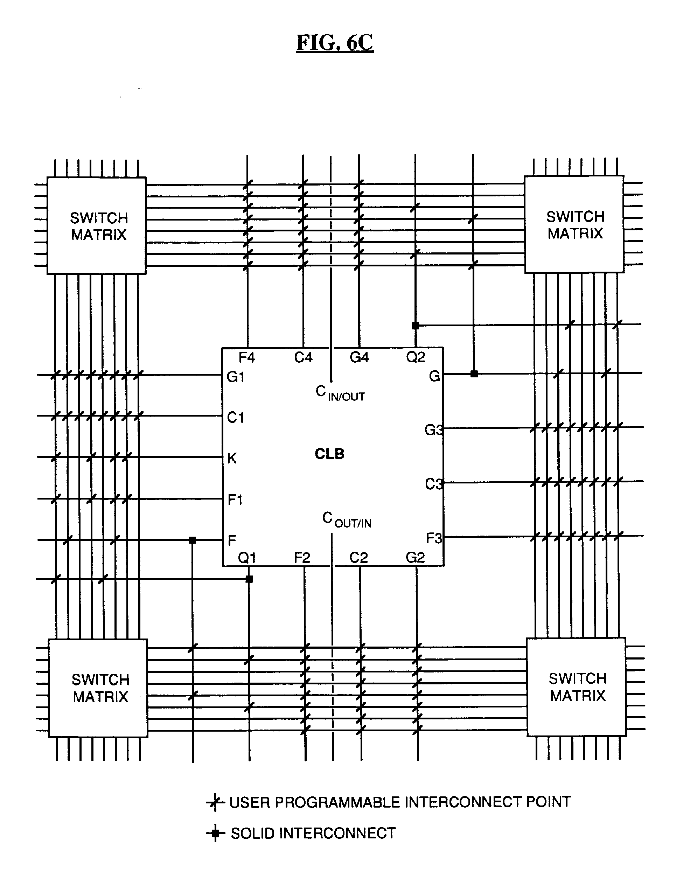

At step 530 a count is taken (sections count) of the number of partitioned sections resulting from the partitioning step 525. In one particular embodiment, the sections count of step 530 represents the number of function generators $f_{xy}$ (Fig. 2B) that are to be consumed in accordance with partitioning step 525. In another embodiment of the invention (to be more fully described below) the sections count of step 530 represents an estimate of the number of logic areas $LA_{xy}$ that are to be consumed as a result of step 525 in situations where each logic area (e.g., CLB 600 of Fig. 6A) contains more than one function generator (e.g., $f_F$, $f_G$ and $f_H$ of Fig. 6B). In the latter case, the estimate is derived from the number of function generators consumed by step 525.

At step 540, a comparison is made to determine whether the present sections count is less than the previous-best-section-count. If it is. then the process proceeds to step 550 where the present count becomes a new previous-best-section-count and the partitioning last created at partitioning step 525 is tagged as the so_far_best partitioning result.

The process 500 then proceeds from either step 540 or step 550 to step 560 where the duplication range is altered to see if some other duplication range will provide a better count than the previous-best-section-count. By way of example, one or both of range limits $fo_H$ and $fi_H$ may be incremented by one at step 560.

From step 560, the process loops back 570 to step 515. Steps 515 through 560 are repeated a plurality of times. The outer loop 570 of process 500 is designed to converge on an optimum duplication range which will produce a minimum number of partitioned sections, and thus ultimately at the end of the chip layout and configuration procedure. a physical implementation of the logic design which utilizes a minimum number of function-implementing areas (e.g., $LA_{11}$, $LA_{12}$, $LA_{13}$, etc.). The user-defined loop-limit is tested at step 560, and when exceeded, the process 500 is exited. The so far best partitioning method is the one used for the chip layout process.

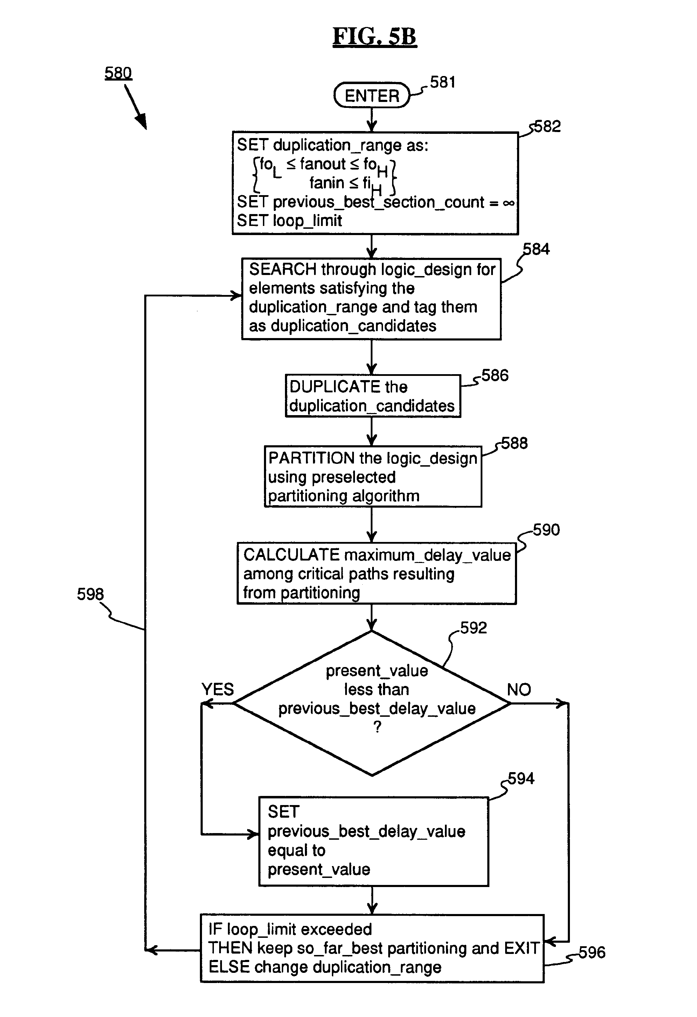

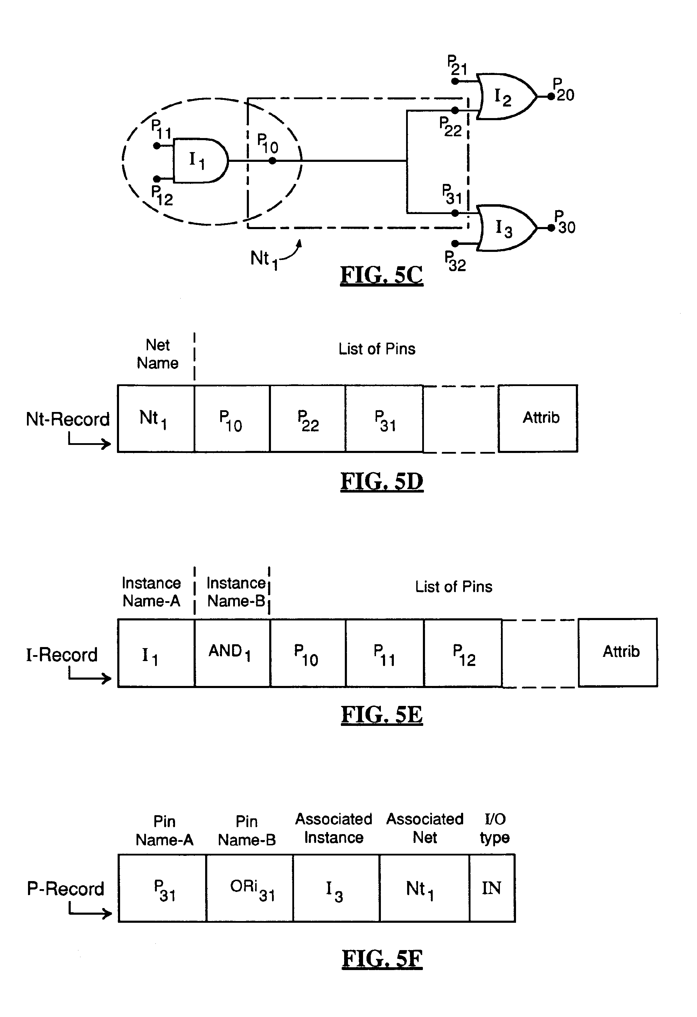

Referring to Figure 5B, a process 580 for minimizing signal propagation time in critical signal paths (or keeping such time within acceptable limits) is illustrated by way of a flow chart. The duplication range is adjusted in step 596 to produce a logic design partitioning which minimizes signal propagation times in user-defined critical paths or at least keeps the times below a user-defined maximum level. Steps 581, 582, 584, 586, 588, 594, 596 and 598 of Fig. 5B correspond to the similarly placed steps of Fig. 5A. Step 590 assumes a predetermined inter-area delay between function generators that are mapped by step 588 and adds these delays up along user defined branches of a circuit tree. The sums are compared against either a set of previous best sums and/or against user defined maximum values in order to find a partitioning method which satisfies predefined timing constraints. A combination of process 500 and 580 is also contemplated for producing a logic design partitioning which balances the desire for a minimum number of partitioned sections against a need to minimize or keep signal propagation times in critical paths below a pre-defined maximum level.

A particular embodiment of the process charted by Fig. 5A will now be explained in more detail as applied to a specific physical implementation (the CLA chip of Figs. 6A-6C which is described later).

Some terms need to be defined in advance. Referring to Fig. 5C, the term "instance" is used below to represent each Boolean primitive (e.g., gates $I_1$, $I_2$ and $I_3$) in a Boolean logic tree. The term "pins" refers to the input and output terminals of each instance (e.g., pins $P_{10}$, $P_{11}$ and $P_{12}$ belong to instance $I_1$). The term "net" refers to a conductive link joining two or more pins (e. g., net $Nt_1$, joins pins $P_{10}$, $P_{22}$ and $P_{31}$).

Referring to Fig. 5D a "net record" is a digital data structure (Nt-Record) defined in a computer-readable memory device (not shown). The net record comprises two or more pin-identifying data pieces which identify the two or more pins (e.g., $P_{10}$, $P_{22}$ and $P_{31}$) belonging to a corresponding net (e.g., $Nt_1$ of Fig. 5c). The net record (Fig. 5D) often includes one or more name-of-net data pieces which are used to identify the net by one or more names, (e.g., "$Nt_1$"). The net record may optionally comprise further data pieces defining certain "attributes" of the net such as whether the net needs to be implemented with long or short metal wires, whether it is a ground line, etc. A collection of net records defines a "nets table" (not shown).

Referring to Fig. 5E, an "instance record" is a data structure (I-Record) defined in a computer-readable memory device to comprise two or more pin-identifying data pieces which identify two or more pins (e.g.. $P_{10}$, $P_{11}$ and $P_{12}$) belonging to a corresponding instance. The instance record often includes one or more name-of-instance data pieces which are used to identify the corresponding instance (e.g., "$I_1$" or "$AND_1$") and additional attributes data. A collection of instance records defines an "instances table" (not shown).

Referring to Fig. 5F, a "pin record" is a data structure (P-Record) defined in a computer-readable memory device for identifying a unique pin (e.g., $P_{31}$) and for associating that pin with a corresponding instance (e.g., $I_3$) as well as a corresponding net (e.g., $Nt_1$). The pin record usually includes additional attribute data which for example identify the pin's function as input, output, bidirectional or don't care. A collection of pin records defines a "pins table".

A "netlist" is a database construct defined in a computer readable memory device (e.g.. a magnetic disk, a tape, RAM, ROM, etc.) to include the following information:

(A) A table of net records, known as the "nets table".

(B) A table of instance records, known as the "instances table".

Each Net record in the nets table (A) defines the following information:

(A.1) Zero or more names assigned to the net (e.g., Nt,);

(A.2) An index number (e.g., 0, 1, 2, 3 ...) which represents the location of the net record in the net table;

(A.3) A list of pins which are connected to the net, known as the "net-pin table"; and

(A.4) A set of boolean flags describing the net's attributes. These attributes include whether the net must be explicitly expressed as a physical wire in the physical circuit or whether its driving instance can be absorbed into a function-implementing equivalent (e.g.. a function generator) such that the net is not explicitly expressed; whether the net represents the GND or VCC net; and so forth.

Each Instance record in the instances table (B) defines the following information:

(B.1) At least one name which uniquely distinguishes the instance from among all other instances in the netlist;

(B.2) A number which represents the location of the Instance record in the instances table.

(B.3) An instance type number which describes the function of the instance: for example whether it performs an AND, OR, or flipflop operation.

(B.4) A list of pins which are connected to the instance, known as the "instance-pin table".

(B.5) A set of boolean flags describing the instance attributes.

The attribute flags (B.5) include a duplication-candidate authorization flag which is used in accordance with the invention to determine whether the instance is duplicatable or not. If the flag is set to TRUE (Boolean 1) then the instance can be duplicated. If the flag is set to FALSE (Boolean 0) then the computer system is blocked from duplicating the instance.

Each Pin referenced by the net-pin and instance-pin table is represented by the following information, also recorded on the memory device which stores the (A) nets table and (B) instances table:

(C.1) At least one name which uniquely distinguishes the pin from among all other pins belonging to the instance;

(C.2) An instance number indicating which instance the pin belongs to;

(C.3) A net number indicating which net the pin belongs to; and

(C.4) A direction value indicating whether the pin is an input pin, an output pin, or a bidirectional pin.

A "Boolean gate tree" is a digital logic structure defined in a computer-readable memory device and composed of one or more signal input terminals and/or one or more interconnected instances. The elements of this logic structure are referred to as "tree nodes" here. A "Fanout-free" Boolean gate tree is defined as a logic structure having one "root" node and zero or more "progeny" nodes springing from the root node. Each node of the tree is described by the following collection of data (stored in a computer-readable memory device):

(D.1) An identifier pointing to the parent node, if any, of the present tree node. The root node of the tree has no parent node.

(D.2) A table of next-succeeding nodes, known as the node's children. If a tree node has no children, it is known as a "leaf node".

(D.3) Either the netlist instance name which is represented by the present node, or a special identifier to indicate that the present node represents a "real input" terminal supplying an external input signal to the tree.

(D.4) If the present tree node is an instance, the netlist net number of the net record which corresponds to the output net of the present instance (the present tree node).

(D.5) The minimum number of function generators required to represent this tree node and its children.

(D.6) The number of "real" inputs that this tree node will require if the minimum number of function generators (D.5) is used to represent the node and its children.

(D.7) A set of boolean flags describing the attributes of the present tree node. These attributes include whether or not the tree node represents a duplicated logic gate; whether or not the node is part of a special H function generator (to be described shortly); whether or not the node was decomposed from a parent node; and whether or not the node should be represented in a function generator that includes the node's parent (its inclusion is "implied"). An example of an instance whose inclusion should be implied is element $E_1$ of Fig. 3B. $E_1$ is the child of element $E_2$. When the functionality of parent element $E_2$ is implemented by a function generator, the function of child $E_1$ should be included in that function generator as implied by partition box $PA_{12}$.

The special "H" function generator of definition D.7 is now explained in more detail. The logic array of Figure 2B was drawn with only one function generator $f_{xy}$ in each function-implementing area $LA_{xy}$. This was done to simplify the understanding of how element duplication can result in the need for fewer function-generators, and hence, a fewer number of function-implementing areas ($LA_{11}$, $LA_{12}$, $LA_{13}$, etc.) and/or smaller signal propagation times.

Logic areas can have more than one function generator within their boundaries. Referring now to the top plan view of Fig. 6A, there is shown a general structure of more complex function-implementing CLA chip 700 having an array of configurable logic blocks (CLB's) 600, switching matrices (SWM's) 601, long-lines 602, short-lines 603 and carry-propagating lines 604. The CLB's 600 are connected to one another by way of one or more of elements 601-604.

Referring to Fig. 6B, each configurable logic block (CLB) 600 includes first through third function generators respectively denoted as $f_F$, $f_G$, $f_H$. The first function generator $f_F$ has four input terminals, F1, F2, F3 and F4, each extending out of the CLB 600 and a single output terminal F0 contained within the CLB 600. A memory unit M16 having sixteen user-configurable memory cells is included in function generator $f_F$ so that function generator $f_F$ can implement any Boolean logic function having from one to four input terms (bits) and a single output term (bit). Data is loaded into the memory unit M16 through a serial shift register chain (not shown) which further includes the other user-configurable memory units (labeled M16, M8, M2, M) of other components shown in Fig. 6A.

The second function generator $f_G$ similarly has four input terminals, G1, G2, G3 and G4, each extending out of the CLB 600 and a single output terminal, G0. Function generator $f_G$ also includes a 16 bit user-configurable memory unit M16 for implementing any Boolean function having up to four input signals and one output signal.

The third function generator $f_H$ has only three input terminals, H1, H2, H3; and only one of these, H1, extends out of the CLB 600. The other two input terminals, H3 and H2, respectively connect to the F0 and G0 output terminals of first and second function generators, $f_F$ and $f_G$. Only eight memory cells are provided in the user-configurable memory unit M8 of the third generator $f_H$.

The output terminal H0 of the third function generator $f_H$ connects to a first input terminal of a user programmable multiplexer 610. A second input terminal of multiplexer 610 connects to output terminal G0 of the second function generator $f_G$. By appropriate setting of a one-bit memory cell M belonging to multiplexer 610, a user can select the signal of either terminal G0 or H0 as the source of a buffered CLB output signal, G. Buffering amplifier 615 is interposed between the output terminal of multiplexer 610 and the CLB output node, G.

The H0 output terminal is also connected to one input terminal of a second multiplexer 620 (also user configurable) whose other input terminal is connected to function generator output terminal F0. This second multiplexer 620 sources a second buffered CLB output signal, F, which passes through amplifier 617.

CLB 600 further includes a pair of flip flops. $FF_1$ and $FF_2$. Each of these flip flops, $FF_1$ and $FF_2$, includes a data input terminal (D), a data output terminal (Q), a clock input terminal (>), a clock enable terminal (EC), a data pre-set terminal (SD) and a data reset terminal (RD). The Q output signals of $FF_1$ and $FF_2$ are respectively buffered by amplifiers 616 and 614 to produce CLB registered output signals Q1 and Q2.

User-configurable multiplexers 631 and 632 are included within the CLB 600 for supplying either an inverted (K*) or non-inverted (K) version of an external clock signal, K, to the clock input terminals (>) of respectively

flip flops, $FF_1$ and $FF_2$. User-configurable multiplexers, 641 and 642, are further provided within the CLB 600 for providing either a constant logic one ("1") or an external clock enabling signal C4 to the clock enable terminals (EC) of respective flip flops, $FF_1$ and $FF_2$. Set/reset control units 651 and 652 are user-configurable to apply one or neither of a set command or a reset command to respective flip flops, $FF_1$ and $FF_2$ in response to an external S/R signal (also denoted as control signal C3). User configurable multiplexers 661 and 662 each have four input terminals for supplying to the respective data-input terminals (D) of flip flops, $FF_1$ and $FF_2$, a user-selected one of the function output signals on terminals F0, G0 and H0, or an externally provided input signal, DIN (also denoted as control signal C2).

Moreover, a carry-propagating circuit 670 is included within CLB 600 for quickly propagating carry signals to or from other like CLB's (Fig. 6B) located directly above and below the CLB 600 along vertically extending carry-propagation lines 604 as illustrated in Fig. 6A.

Referring to Fig. 6C, each CLB has its function input terminals, F1-F4, G1-G4 and H1 physically arranged as shown together with function output terminals, F and G, as well as registered outputs Q1 and Q2. (Input terminal C1 is synonymous with function generator input terminal H1, while input terminals C2, C3 and C4 correspond respectively to the DIN, S/R, and EC signals shown in Fig. 6A.).

With the structure of a CLB 600 now explained, it can be seen that tree-like networks can be implemented within each CLB 600 by coupling the H0 output terminal of the $f_H$ generator to one of the CLB output terminals (F, G, Q1 or Q2) and by configuring (programming) the $f_H$ generator to produce an H0 output signal which is responsive to signals present at one or both of its H2 and H3 input terminals.

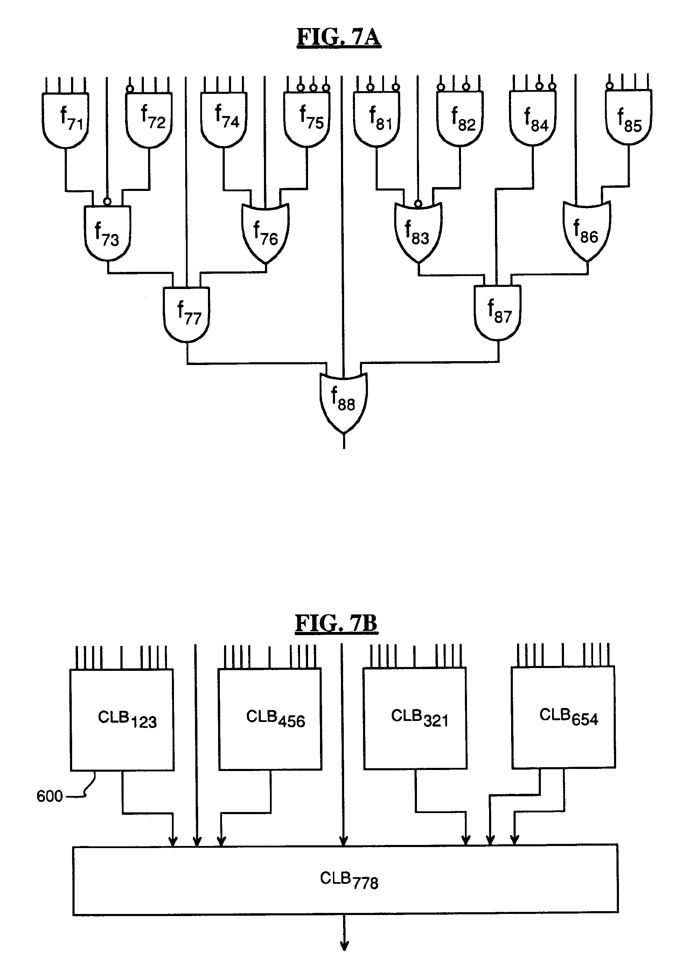

Referring to Fig. 7A, it often turns out that tree-like networks form naturally in logic designs. For example, the output signals of first and second function elements, $f_{71}$ and $f_{72}$, become inputs of a third function element $f_{73}$. Element $f_{73}$, as shown, is the only child of elements $f_{71}$ and $f_{72}$. Design element $f_{73}$ has three input terminals while design elements $f_{71}$ and $f_{72}$ have four input terminals each. In such a case, it is preferable to implement the composite tree structure formed by elements $f_{71}$, $f_{72}$, and $f_{73}$ within a single CLB 600 so that the resources of that CLB 600 are fully utilized and so that inter-CLB (out-of-the-CLB) routing wires are not wasted. Referring back to Fig. 6B, function generator $f_F$ would implement the function of first design element $f_{71}$, function generator $f_G$ would implement the function of second design element $f_{72}$ and function generator $f_H$ would implement the function of third design element $f_{73}$. The $f_{71}$, $f_{72}$ and $f_{73}$ tree structure maps fully into an FGH tree pattern within the CLB.

Referring to Figure 7B, the block which absorbs the functionality of the $f_{71}$, $f_{72}$ and $f_{73}$ tree is illustrated as $CLB_{123}$. Similarly, it would be desirable to map functions $f_{74}$, $f_{75}$ and $f_{76}$ into a second block $CLB_{456}$ and to map functions $f_{81}$, $f_{82}$ and $f_{83}$ into a third block $CLB_{321}$. It is further preferable to map functions $f_{85}$ and $f_{86}$ into the respective F and H generators of a fourth block $CLB_{654}$. (This defines an FH tree pattern rather than an FGH tree pattern.) The G generator of the fourth block $CLB_{654}$ is free to absorb the function of design element $f_{84}$. And to finish Fig. 7A, it is desirable to map functions $f_{77}$, $f_{87}$ and $f_{88}$ into a fifth block $CLB_{778}$.

In view of this, it is a feature of the present invention to tune the partitioning process so as to maximize the chances for such desirable mappings of design elements into logic areas. This applies to cases where the function-implementing areas of a CLA chip are each defined as a CLB having multiple function generators (Fig. 6B) rather than as a logic area $LA_{xy}$ having only a single function generator (Fig. 2B). The partition tuning methods (of, for example, Fig. 5A and/or Fig. 5B) are structured to focus on the number of resulting CLB's and/or the inter-CLB signal propagation delays rather than merely on the number of resulting function generators and/or inter-generator propagation delays.

The steps for realizing a minimum number of CLB's are set forth in the following nested pseudo-code listing:

**Main Algorithm:**

```
Obtain the netlist.

set best-clb-count-so-far = infinity.

For fanout-limit equal from 2 to user-specified-
fanout-limit:
```

*map-boolean-gates-to-function-generators* using *fanout-limit* to obtain *clb-count*.

If *clb-count* < *best-count-so-far* then:

set *best-clb-count-so-far* = *clb-count*.

set *best-fanout-limit* = *fanout-limit*.

End If.

End For.

*map-boolean-gates-to-function-generators (best-fanout-limit)*.

---

**Map-boolean-gates-to-function-generators** using *fanout-limit* to obtain *clb-count*:

Create a single *forest-root* to hold fanout-free combinatorial-gate trees.

For each instance in the netlist:

If *the-instance-is-a-duplication-candidate* using *fanout-limit* then:

Mark the instance as duplicatable.

Allocate a *fanout-location* table, which is initially empty.

End If.

End For.

Create *root-instance-table*, which is initially empty.

For each instance in the netlist:

If *the-instance-is-a-boolean-gate* then:

If *the-boolean-gate must-be-at-the-root-of-a-tree* then:

```
        add the instance to the root-instance-
        table.
    End If.
    For each instance in the root-instance-table:
        build-a-fanout-free-combinatorial-gate-tree
        using instance and forest-root.
    End If.
  End If.
End For.
add-duplication-candidates-to-the-fanout-free-trees.
use-map.c-to-map-trees-to-function-
generators to obtain clb-count.
return clb-count.
```

---

**The-instance-is-a-duplication-candidate** using *fanout-limit*
**to obtain** *a-boolean-value*:

```
    If NOT the-instances-is-a-boolean-gate then return
    FALSE.
    If instance-fanin-count > 2 then return FALSE.
    If instance-fanout-count > fanout-limit then return
    FALSE.
    If NOT all-instances-on-the-output-net-are-boolean
    then return FALSE.
    If the-output-net-must-be-explicit then return FALSE
    Return TRUE.
```

---

**The-boolean-gate-must-be-at-the-root-of-a-tree** to obtain *a-boolean-value*:

> If *the-output-net-has-the-user-explicit-flag* then return TRUE.
>
> If NOT *all-instances-on-the-output-net-are-boolean* then return TRUE.
>
> If *instance-fanout-count* > 1 then return TRUE.
>
> Return FALSE.

---

**Build-a-fanout-free-combinatorial-gate-tree** using *the-instance* and *parent-tree-node*:

> If *the-instance-is-a-boolean-gate* then:
>
>> If *the-instance* does not appear in the *root-instances-table* then:
>>
>>> Create a *tree-node* for *the-instance*.
>>>
>>> Add the *tree-node* as a child of the *parent-tree-node*.
>>>
>>> For each *net* in the fanin of *the-instance*:
>>>
>>>> For each *src-instance* which drives the *net*:
>>>>
>>>> *build-a-fanout-free-combinatorial-gate-tree* using *src-instance* and *tree-node*.
>>>>
>>>> End For.
>>>
>>> End For.
>>
>> Else If *the-instance* is duplicatable then:
>>
>>> Add the *parent-tree-node* to *the-instance's* *fanout-locations* table.
>>>
>>> End If.

```
End If.
```

---

**Add-duplication-candidates-to-the-fanout-free-trees:**

```
For each instance which has the duplicatable flag set:

    For each child-instance which drives an input of the instance:

        If the duplication flag of the child-instance is set then:

            clear the duplication flag of the instance.

        End If.

    End For.

End For.

For each instance which has the duplicatable flag set:

    For each tree-node in the instance's fanout-locations table:

        Create a child-tree-node for the instance.

        Add the child-tree-node as a child of the tree-node.

    End For.

End For.
```

---

**The-instance-is-a-boolean-gate to obtain a-boolean-value:**

```
    If the type of the-instance is AND then return TRUE.

    If the type of the-instance is OR then return TRUE.

    If the type of the-instance is XOR then return TRUE.
```

```
If the type of the-instance is NAND then return TRUE.

If the type of the-instance is NOR then return TRUE.

If the type of the-instance is XNOR then return TRUE.

If the type of the-instance is INV then return TRUE.

return FALSE.
```

---

**All-instances-on-the-output-net-are-boolean to obtain a-boolean-value:**

```
Set output-pin to 0.

For each pin on the-instance:

        If the pin direction is output, then set output-pin to pin.

End for.

If output-pin = 0 then return FALSE.

set output-net to output-pin's net.

For each pin on the output-net:

        Set the-net-instance to the pin's instance.

        If NOT the-instance-is-a-boolean-gate then return FALSE.

End for.

return TRUE.
```

---

**The-output-net-must-be-explicit to obtain a-boolean-value:**

```
If the explicit flag of the-net is set then return TRUE.

return FALSE.
```

-----------------------------------------------------------------------

**Instance-fanout-count to obtain the-fanout-number:**

```
Set output-pin to 0.

Set the-fanout-number to 0.

For each pin on the-instance:

        If the pin direction is output then set output-pin to pin.

End for.

If output-pin = 0, then return 0.

For each pin on the output-net:

        If pin is not output-pin then increment the-fanout-number.
```

```
End for.

    return the-fanout-number.

------------------------------------------------------------------------

Map-trees-to-function-generators to obtain clb-count:

    Set F_total to 0 -- number of F only function generator patterns.

    Set FH_total to 0 -- number of F-H function generator patterns.

    Set FGH_total to 0 -- number of F-G-H function generator patterns.

    For each (child) tree of the forest-root:

        Map-tree-to-fgs to obtain F_count, FH_count and FGH_count.

        Add F_count   to F_total.

        Add FH_count  to FH_total.

        Add FGH_count to FGH_total.

    End for.

    -- *** HERE IS THE KEY TO ESTIMATING THE NUMBER OF RESULTING CLBS *** --

    -- -------------------------------------------------------------- --

    -- FGH patterns take up one clb; FH patterns also require one clb;

    -- an F pattern is equivalent to a G pattern; a separate G pattern

    -- may fit into the same clb as an FH pattern.  Hence we reduce the

    -- number of F patterns by the number of FH patterns.  The result

    -- is divided by 2 (a clb can contain 2 F patterns, one is F, the

    -- other is G) and rounded up [the +1)/2 syntax].  If there are

    -- more FH patterns than F patterns, then all F patterns may be

    -- "absorbed" into the clbs which implement FH patterns, and this

    -- is the meaning of the max(...,0) syntax.

    -- -------------------------------------------------------------- --

    Set clb-count to FGH total + FH total + max ((F_total-FH_total + 1)/2,0).

    return clb-count.

------------------------------------------------------------------------

Map-tree-to-fgs to obtain F_count, FH_count and FGH_count:

    set nextfgnum to 1

    perform map.c  CODE FUNCTION:  map_to_fgs(tree,fgwidth=4,Hfgwidth=3);

    perform map.c  CODE FUNCTION:  fc= set-fungen-numbers(tree,nextfgnum-1,&nextfgnum);

    set F_count to fc

    set FH_count and FGH_count to 0

    count-the-fgs using the tree and F_count, FH_count and FGH_count
```

```
        return F_count, FH_count and FGH_count
-----------------------------------------------------------------------------
Count-the-fgs using tree-node, F_count, FH_count and FGH_count:
        set subtree-count = 0.
        for each child-node of the tree-node:
                Count-the-fgs using child-node, F_count, FH_count and FGH_count.
                if child-node has children then increment subtree-count.
        End for.
        if Hfg-flag of tree-node is set then:
                if Hfg-flag of the parent of tree-node is NOT set then:
                    if subtree-count is 1 then:
                        decrement tF_count by 2
                        increment tFH_count by 1
                    else if subtree-count is 2 or 3 then
                        decrement tF_count by 3
                        increment tFGH_count by 1
                    End if.
                End if.
        End if.
-----------------------------------------------------------------------------
```

The above process is structured to conform with the XACT™ layout tools kit provided by Xilinx Inc. of San Jose, California for configuring their XC4000™ family of CLA chips. The partitioned netlist files produced in the above process are fixed in a computer-readable medium and thus they are articles of manufacture which are used in the layout and implementation process to fabricate physical circuits satisfying user-defined functional descriptions. Many variations to the disclosed invention will become apparent to those skilled in the art after reading the above. For example, CLB's having a different number or pattern of function generators may be employed. The boundary rules may change from one CLB to another in cases where a mix of different CLB's is employed on one chip. It should be understood that the above detailed description is intended to merely illustrate rather than limit the scope of the following claims.

**Claims**

1.  A circuit layout method including the steps of:
    searching through a pre-defined logic design;
    tagging certain ones of logic elements within the logic design which satisfy a pre-defined fan-out range as duplication candidates; and
    duplicating the duplication candidates within the logic design.

2.  A method of fabricating a physical circuit from a circuit design having a multiplicity of interconnected circuit components where each of the components has at least one signal output terminal and one or more signal input terminals, where the output terminal of at least one component is coupled to drive a respective one or more input terminals of one or more other components thereby defining a circuit tree, where the physical circuit has a plurality of function-implementing areas each constrained by a predetermined boundary rule that allows no more than a first number (J) of independent signal input wires and no more than a second number (K) of independent signal output wires to cross the boundary of that function-implementing area, the method comprising the steps of:
    identifying as a duplication-candidate, a circuit design component whose output terminal drives input terminals of more than one other component in the circuit tree, and
    replacing the duplication-candidate with a plurality of duplicate components where corresponding input terminals of the duplicate components are connected to each other while corresponding output terminals of the duplicate components are independent of one another.

3.  A method as claimed in claim 2 comprising, after the replacing step, the step of partitioning the circuit design into design sections each satisfying the boundary rule.

4.  A method as claimed in claim 3 comprising, after the partitioning step, the step of implementing each design section in a corresponding function-implementing area of the physical circuit.

5.  A method as claimed in claim 2, 3 or 4 wherein the resulting physical circuit includes a monolithic substrate having the function-implementing area uniformly distributed across its surface.

6.  A method as claimed in claim 2, 3, 4 or 5 wherein each function-implementing area includes a first lookup table means (F) for implementing any Boolean logic function having a first number, $I_F$, of input terms and a fourth number, $O_F$, of output terms.

7.  A method as claimed in claim 6 wherein each function-implementing area includes a second lookup table means (H) for implementing any Boolean logic function having a third number, $I_H$, of input terms and a fourth number, $O_H$, of output terms.

8.  A method as claimed in claim 7 wherein at least one of the output terms of the first lookup table means (F) serves as an input term of the second table lookup means (H).

9. A machine for automatically mapping parts of a pre-defined logic design into function-implementing area of a configurable logic array to thereby implement the pre-defined logic design, the logic design including a plurality of circuit elements having input and output nodes coupled one to the next, and being described by net-list data contained in a machine-readable memory device, the machine comprising:

duplication range defining means for defining a duplication range as $fo_L \leqq fanout \leqq fo_H$ where fanout is a characterization number of next-succeeding input nodes driven by an output node of a characterized circuit element;

search means for searching through the net-list data of the memory device and identifying circuit elements satisfying the duplication range definition; and

element duplication means for replacing each identified circuit element in the net-list with a plurality of duplicate elements.

10. A machine as claimed in claim 9 comprising tuning means for altering the duplication range defining means to define a new duplication range, and comparison means for comparing characteristics of a logic array configured in accordance with the new duplication range against like characteristics of a logic array configured in accordance with a previous duplication range.

11. A machine as claimed in claim 10 wherein the characteristics include a count of the number of function generators consumed in the logic array for implementing the logic design.

12. A machine as claimed in claim 10 or 11 wherein the characteristics include a count of the number of function-implementing areas consumed in the logic array for implementing the logic design.

13. A machine as claimed in claim 10 or 11 wherein the characteristics include a signal propagation time from one design element to a second design element of the logic design.

14. A configurable logic array the circuitry of which is derived from an initial function definition including a first number of function elements and a second number of nets linking the function elements, wherein the circuitry of the logic array is further derived from a duplicate-inclusive function definition having a third number of function elements greater than the first number, the duplicate-inclusive definition including duplicates of elements defined in the initial function definition.

# FIG. 1

# FIG. 2A

## FIG. 2B

## FIG. 3A

**FIG. 3B**

## FIG. 4

# FIG. 5A

500

( ENTER )——501

SET duplication_range as: ——510
$$\left\{ \begin{array}{c} fo_L \le fanout \le fo_H \\ fanin \le fi_H \end{array} \right\}$$
SET previous_best_section_count = ∞
SET loop_limit

SEARCH through logic_design for ——515
elements satisfying the
duplication_range and tag them
as duplication_candidates

DUPLICATE the ——520
duplication_candidates

PARTITION the logic_design ——525
using preselected
partitioning algorithm

COUNT the number of ——530
partitioned sections
resulting from partitioning

540

YES ◇ present_count
less than
previous_best_section_count
? ◇ NO

570

SET ——550
previous_best_section_count
equal to present count
identify present partitioning as
so_far_best partitioning

IF loop_limit exceeded
THEN keep so_far_best partitioning and EXIT
ELSE change duplication_range ——560

## FIG. 5B

580

ENTER ⟩—581

SET duplication_range as: —582
$$\left\{ \begin{array}{c} fo_L \le fanout \le fo_H \\ fanin \le fi_H \end{array} \right\}$$
SET previous_best_section_count = ∞
SET loop_limit

SEARCH through logic_design for —584
elements satisfying the
duplication_range and tag them
as duplication_candidates

DUPLICATE the —586
duplication_candidates

PARTITION the logic_design —588
using preselected
partitioning algorithm

CALCULATE maximum_delay_value —590
among critical paths resulting
from partitioning

592

present_value
less than
previous_best_delay_value
?

YES          NO

SET —594
previous_best_delay_value
equal to
present_value

598

IF loop_limit exceeded
THEN keep so_far_best partitioning and EXIT
ELSE change duplication_range —596

EP 0 486 248 A2

**FIG. 5C**

**FIG. 5D**

**FIG. 5E**

**FIG. 5F**

# FIG. 6A

700

FIG. 6B

# FIG. 6C

✳ USER PROGRAMMABLE INTERCONNECT POINT

✚ SOLID INTERCONNECT

## FIG. 7A

## FIG. 7B